(19) Europäisches Patentamt / European Patent Office / Office européen des brevets

(11) **EP 3 686 676 B1**

(12) **FASCICULE DE BREVET EUROPEEN**

(45) Date de publication et mention de la délivrance du brevet:
**26.03.2025 Bulletin 2025/13**

(21) Numéro de dépôt: **20153724.8**

(22) Date de dépôt: **24.01.2020**

(51) Classification Internationale des Brevets (IPC):
**G03F 7/20** *(2006.01)*  **G01B 15/04** *(2006.01)*
**G01N 23/2251** *(2018.01)*  **H01J 37/28** *(2006.01)*

(52) Classification Coopérative des Brevets (CPC):
**G03F 7/70625;** G01N 23/2251; G01N 2223/606;
G01N 2223/611; H01J 2237/22; H01J 2237/2814

(54) **METHODE D'ESTIMATION DE LA TOPOGRAPHIE LOCALE D'UN ECHANTILLON A PARTIR D'IMAGES DE MICROSCOPIE ELECTRONIQUE A BALAYAGE ET D'UN MODELE MATHEMATIQUE**

SCHÄTZUNGSMETHODE DER LOKALEN TOPOGRAPHIE EINER PROBE AUF DER GRUNDLAGE VON BILDERN EINES RASTERELEKTRONENMIKROSKOPS UND EINEM MATHEMATISCHEN MODELL

METHOD FOR ESTIMATING THE LOCAL TOPOGRAPHY OF A SAMPLE FROM IMAGES FROM ELECTRONIC SCANNING MICROSCOPY AND A MATHEMATICAL MODEL

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **25.01.2019 FR 1900645**

(43) Date de publication de la demande:
**29.07.2020 Bulletin 2020/31**

(73) Titulaire: **Commissariat à l'Energie Atomique et aux Energies Alternatives**
**75015 Paris (FR)**

(72) Inventeurs:
• **VALADE, Charles**
  **38054 Grenoble Cedex 9 (FR)**
• **HAZART, Jérôme**
  **38054 Grenoble Cedex 9 (FR)**

(74) Mandataire: **Cabinet Camus Lebkiri**
  **25 rue de Maubeuge**
  **75009 Paris (FR)**

(56) Documents cités:
**US-A1- 2005 285 034    US-A1- 2006 210 143**
**US-A1- 2007 198 955**

• **CARL GEORG FRASE ET AL: "CD characterization of nanostructures in SEM metrology", MEASUREMENT SCIENCE AND TECHNOLOGY, IOP, BRISTOL, GB, vol. 18, no. 2, 1 February 2007 (2007-02-01), pages 510 - 519, XP020118520, ISSN: 0957-0233, DOI: 10.1088/ 0957-0233/18/2/S26**

EP 3 686 676 B1

**Description**

**DOMAINE TECHNIQUE DE L'INVENTION**

Le domaine technique de l'invention est celui de l'estimation de la topographie locale d'échantillons par microscopie électronique à balayage, utilisant un modèle mathématique.

La présente invention concerne une méthode d'estimation de la topographie locale d'un échantillon et en particulier une méthode d'estimation de la topographie locale d'un échantillon à partir d'images de microscopie électronique à balayage et d'un modèle mathématique.

**ARRIERE-PLAN TECHNOLOGIQUE DE L'INVENTION**

Dans une optique d'amélioration de la rentabilité, l'industrie cherche à développer des dispositifs à l'architecture non planaire (FinFET, FinFET Tri-gate, Gate-all-around FET etc.). Elle développe également diverses technologies permettant de réaliser des fonctions variées, intégrées sur silicium, menant à des architectures tridimensionnelles pouvant être complexes (imageurs, MEMS, photonique, mémoires 3D etc.).

Le développement de ces nouvelles architectures ne peut se faire qu'en parallèle d'une métrologie nanométrique permettant le dimensionnement dans les trois dimensions de l'espace.

Dans les applications de correction optique de proximité ou OPC, il est nécessaire de mesurer avec précision la dimension critique de chaque motif de l'échantillon de manière robuste, c'est pourquoi il peut être intéressant de connaître la topographie du motif observé pour pouvoir, par exemple, mesurer les dimensions critiques à une hauteur constante.

Plusieurs méthodes sont classiquement utilisées pour réaliser de telles mesures.

Une telle mesure est par exemple réalisée en acquérant des coupes transversales de l'échantillon, micro-usinées par sonde ionique focalisée, puis imagées par microscopie électronique à balayage, ou à transmission. Bien que permettant d'obtenir des résultats précis, cette méthode est longue et entraîne une destruction locale de l'échantillon testé, ce qui rend impossible son utilisation comme méthode systématique de contrôle dans l'industrie.

Une autre manière de réaliser cette mesure est d'utiliser un microscope à force atomique qui analyse l'échantillon point par point par balayage via une sonde locale, mais cette méthode présente de nombreux inconvénients notamment des problèmes de reproductibilité dus à l'usure rapide de la sonde locale, et de lenteur, ce qui empêche sa mise en œuvre au niveau industriel sur des échantillons comportant un très grand nombre de motifs.

Il a également été proposé d'utiliser un microscope électronique à balayage réalisant des acquisitions rapides, couplé à un modèle mathématique permettant d'estimer la dimension critique par seuillage sur un profil de niveaux de gris. Cependant, de tels modèles mathématiques ne sont adaptés qu'à un certain type de motifs aux caractéristiques proches et ne sont pas généralisables à des motifs ayant des caractéristiques variées.

Il existe donc un besoin d'une méthode permettant de mesurer avec précision la topographie, et notamment la hauteur et l'angle de flanc, de n'importe quel type de motifs de manière rapide, non destructive et reproductible.

Le document US 2006/210143 intitulé « Method and apparatus for measuring shape of a specimen » est connu de l'état de la technique.

**RESUME DE L'INVENTION**

L'invention offre une solution aux problèmes évoqués précédemment, en proposant une méthode permettant de mesurer la hauteur et l'angle de flanc de tous les motifs d'un échantillon sur une très large variété de caractéristiques dimensionnelles, et pouvant être mise en œuvre de manière systématique au niveau industriel.

Un premier aspect de l'invention concerne une méthode d'estimation de la topographie locale d'un échantillon comportant au moins un motif, la méthode comprenant :

- pour chaque motif de l'échantillon :

  ○ une étape d'acquisition, par un microscope électronique à balayage, d'une pluralité d'images du motif, les images étant prises avec différents angles d'incidence ;
  ○ pour chaque image acquise :

  • une étape de calcul d'un profil de niveaux de gris selon un axe donné ;
  • une étape de placement d'une pluralité de descripteurs primaires sur le profil de niveaux de gris calculé ;
  • une étape de calcul de descripteurs secondaires à partir des descripteurs primaires ;
  • une étape d'utilisation d'un modèle mathématique pour calculer des grandeurs topographiques primaires à partir des descripteurs secondaires ;

○ une étape d'estimation de la topographie locale du motif consistant à utiliser le modèle mathématique pour calculer des grandeurs topographiques secondaires à partir des grandeurs topographiques primaires et des descripteurs secondaires précédemment calculées.

Grâce à l'invention, il est possible d'obtenir rapidement, grâce à la rapidité d'acquisition des images par un microscope électronique à balayage, et précisément, en ayant recours à des images à plusieurs angles d'incidence et à un modèle mathématique, la hauteur ainsi que l'angle du flanc de chaque motif d'un échantillon, et plus généralement la topographie de chaque motif de l'échantillon. Le modèle mathématique permet d'obtenir dans un premier temps, des grandeurs topographiques primaires à partir d'une unique image et dans un deuxième temps, des grandeurs topographiques secondaires ne pouvant être obtenues qu'à partir de plusieurs images, et modélise la topographie du motif par une forme caractérisée par ces grandeurs topographiques primaires et secondaires. De plus, l'utilisation du modèle mathématique une fois calibré permet d'estimer la topographie de motifs aux grandeurs topographiques variées avec des taux d'erreur proches de ceux des méthodes de référence actuelles précédemment présentées.

Outre les caractéristiques qui viennent d'être évoquées dans le paragraphe précédent, la méthode selon un premier aspect de l'invention peut présenter une ou plusieurs caractéristiques complémentaires parmi les suivantes, considérées individuellement ou selon toutes les combinaisons techniquement possibles.

Selon un mode de réalisation, la méthode selon un premier aspect de l'invention comporte une première étape de calibration du modèle mathématique à partir de topographies de référence.

Selon un premier sous-mode de réalisation, les topographies de référence sont obtenues à l'aide d'au moins une technique de microscopie différente de la microscopie électronique à balayage.

Selon un exemple de réalisation du premier sous-mode de réalisation précédent, les techniques de microscopie peuvent être choisies parmi la microscopie électronique en transmission ou la microscopie à force atomique.

Ainsi, le modèle mathématique est calibré en utilisant des profils topographiques issus de mesures faites à partir de techniques de microscopie différentes de la microscopie électronique à balayage.

Selon un deuxième sous-mode de réalisation, les topographies de référence sont obtenues par simulation.

Ainsi, le modèle mathématique est calibré en utilisant des topographies obtenues par simulation ce qui permet de calibrer plus vite et sur une diversité plus large de motifs par rapport au cas où l'on utiliserait seulement des images acquises par microscopie plus lentes à obtenir et dont il est difficile de contrôler chaque paramètre.

Selon un mode de réalisation compatible avec le mode de réalisation précédent, la topographie d'un motif est modélisée à l'aide d'un trapèze à coins arrondis.

Selon un exemple de réalisation du mode de réalisation précédent, le trapèze à coins arrondis comporte une petite base, une grande base et deux flancs et peut être caractérisé par les huit grandeurs topographiques suivantes : une courbure basse droite, une courbure basse gauche, une courbure haute droite, une courbure haute gauche, une hauteur, un angle de flanc droit, un angle de flanc gauche et une longueur à une hauteur donnée.

Ainsi, le modèle mathématique estime la topographie du motif en déterminant des grandeurs topographiques propres à un trapèze à coins arrondis.

Selon un mode de réalisation compatible avec les modes de réalisation précédents, les descripteurs primaires sont déterminés à partir de valeurs particulières de la dérivée du profil de niveaux de gris selon l'axe donné.

Ainsi, les descripteurs primaires correspondent à des positions auxquelles les niveaux de gris varient de manière importante, ce qui correspond en général aux bords d'un motif.

Selon un mode de réalisation compatible avec les modes de réalisation précédents, une grandeur topographique primaire est une combinaison linéaire des descripteurs secondaires et de l'angle d'incidence d'une unique image acquise.

Ainsi, les grandeurs topographiques primaires peuvent être directement obtenues à partir d'une unique image acquise.

Selon un mode de réalisation compatible avec les modes de réalisation précédents, une grandeur topographique secondaire est une fonction de grandeurs topographiques primaires et des angles d'incidence de plusieurs images acquises et éventuellement des descripteurs secondaires de plusieurs images acquises.

Ainsi, les grandeurs topographiques secondaires ne peuvent pas être directement obtenues à partir d'une unique image acquise mais à partir de plusieurs images prises avec des angles d'incidence différents.

Un deuxième aspect de l'invention concerne un produit-programme d'ordinateur comprenant des instructions qui, lorsque le programme est exécuté par un ordinateur, conduisent celui-ci à mettre en œuvre les étapes de la méthode selon un premier aspect de l'invention excepté les étapes d'acquisition.

Un troisième aspect de l'invention concerne un support d'enregistrement lisible par ordinateur comprenant des instructions qui, lorsqu'elles sont exécutées par un ordinateur, conduisent celui-ci à mettre en œuvre les étapes de la méthode selon un premier aspect de l'invention excepté les étapes d'acquisition.

L'invention et ses différentes applications seront mieux comprises à la lecture de la description qui suit et à l'examen des figures qui l'accompagnent.

**BREVE DESCRIPTION DES FIGURES**

Les figures sont présentées à titre indicatif et nullement limitatif de l'invention.

- La figure 1 représente un schéma synoptique des étapes de la méthode selon un premier aspect de l'invention.
- La figure 2 représente une modélisation de la topographie d'un motif d'un échantillon, et les grandeurs topographiques associées pour un angle d'incidence nul.
- La figure 3 représente un schéma d'un microscope électronique à balayage imageant un échantillon avec un certain angle d'incidence.
- La figure 4A représente une image d'un échantillon acquise par un microscope électronique à balayage.
- La figure 4B représente le profil de niveaux de gris de l'image de la figure 4A selon un axe donné.
- La figure 4C représente la dérivée du profil de niveaux de gris de la figure 4B.
- La figure 5 représente une modélisation de la topographie d'un motif d'un échantillon, et les grandeurs topographiques associées pour un angle d'incidence nul à gauche et pour un angle d'incidence non nul à droite.

**DESCRIPTION DETAILLEE D'AU MOINS UN MODE DE REALISATION DE L'INVENTION**

Sauf précision contraire, un même élément apparaissant sur des figures différentes présente une référence unique.

Un premier aspect de l'invention concerne une méthode d'estimation de la topographie locale d'un échantillon.

On entend par « topographie locale d'un échantillon », la configuration de la surface de l'échantillon, autrement dit l'identification des reliefs et des creux de l'échantillon, appelés ligne ou espace dans le domaine de la microélectronique.

On entend par « estimation de la topographie locale d'un échantillon », le fait d'évaluer approximativement la topographie locale de l'échantillon.

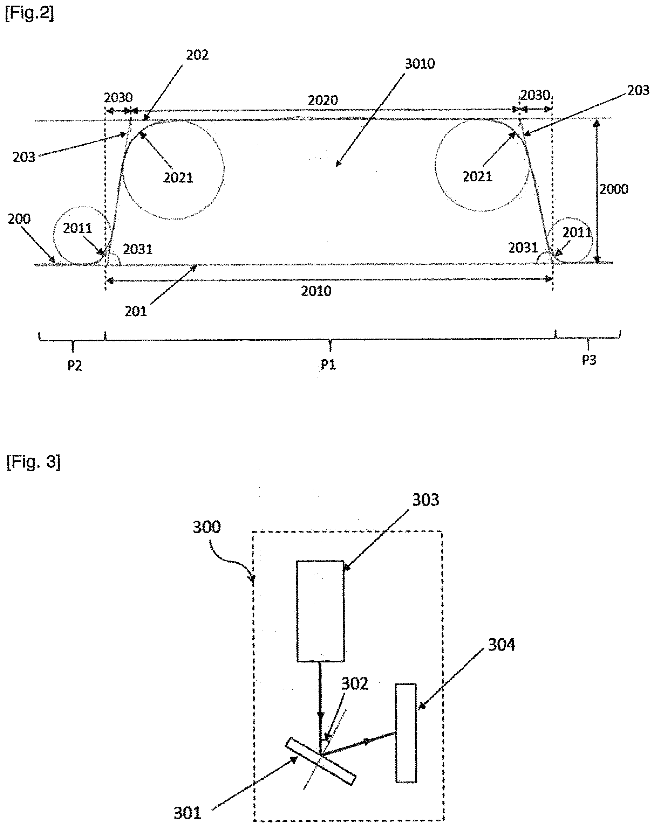

Un échantillon 301, représenté à la figure 3 peut comporter un ou plusieurs motifs 3010 comme représenté sur la figure 2. La topographie de chaque motif 3010 est par exemple modélisée par une forme épousant certains contours d'un trapèze à coins arrondis.

[Fig 2] montre une modélisation 200 d'un motif 3010 de l'échantillon 301 par une forme épousant certains contours d'un trapèze à coins arrondis.

Un « trapèze à coins arrondis » est un trapèze classique dont certains angles ont été remplacés par des arrondis.

On entend par « trapèze classique » un quadrilatère possédant deux côtés opposés parallèles de longueurs différentes. Le côté opposé parallèle de plus petite dimension est communément appelé petite base 202 et le côté opposé parallèle de plus grande dimension est communément appelé grande base 201. Dans un trapèze classique, deux côtés se rejoignent en formant un angle.

Dans la suite de la description, on appelle flancs 203 les deux autres côtés du trapèze classique, c'est-à-dire les côtés reliant la petite base 202 et la grande base 201. On appelle extrémité basse d'un flanc 203, l'extrémité du flanc 203 liée à la grande base 201 et extrémité haute d'un flanc 203, l'extrémité du flanc 203 liée à la petite base 202. On appelle largeur 2030 d'un flanc 203 la distance, selon un axe parallèle à la petite base 202, entre l'extrémité haute et l'extrémité basse du flanc 203. On appelle angle 2031 d'un flanc 203 la valeur de l'angle entre la grande base 201 et le flanc 203.

On qualifie le trapèze de « trapèze à coins arrondis » du fait que chaque flanc 203 rejoint la petite base 202 en formant un arrondi et non un angle comme dans les trapèzes classiques. Autrement dit, l'extrémité haute de chaque flanc 203 est courbe.

La structure d'un trapèze à coins arrondis s'appuie donc sur la structure d'un trapèze classique et certaines grandeurs topographiques de ce trapèze classique peuvent donc servir à caractériser la topographie du trapèze à coins arrondis, comme par exemple la longueur 2020 de la petite base 202, la longueur 2010 de la grande base 201, la largeur 2030 de flanc 203 et l'angle 2031 de flanc 203.

Sur la figure 2, la petite base 202 correspond à la partie haute du motif 3010 de l'échantillon 301 et la grande base 201 correspond à la partie basse du motif 3010 de l'échantillon 301 située à la hauteur à laquelle serait la surface de l'échantillon 301 s'il n'y avait pas de motif 3010. Autrement dit, la hauteur entre la petite base 201 et la grande base 202 correspond à la hauteur 2000 du motif 3010.

La hauteur 2000 du motif 3010 peut être positive ou négative selon que le motif 3010 est un relief ou un creux.

Par la suite, on appelle « longueur du motif 3010 », la longueur du motif 3010 pour une hauteur donnée. La longueur du motif 3010 est par exemple la longueur 2020 de la petite base 201, c'est-à-dire la longueur du motif 3010 à la hauteur 2000 du motif 3010 ou encore la longueur 2010 de la grande base 201, c'est-à-dire la longueur du motif 3010 à hauteur nulle.

Le motif 3010 de l'échantillon 301 est modélisé par une courbe 200 dont une partie épouse certains contours du trapèze à coins arrondis. Plus particulièrement, cette courbe 200 possède une première partie P1 épousant les flancs 203 et la petite base 202 du trapèze à coins arrondis ainsi qu'une deuxième partie P2 et une troisième partie P3 situées de part et d'autre de la première partie P1 et s'étendant selon un plan comportant la grande base 201. La jonction entre la première partie P1 et la deuxième partie P2 de la courbe 200 forme un arrondi au niveau de l'extrémité basse d'un des flancs 203 et la jonction entre la première partie P1 et la troisième partie P3 de la courbe 200 forme un arrondi au niveau de l'extrémité basse de l'autre flanc 203 du trapèze à coins arrondis.

Pour plus de simplicité, on peut supposer que la courbe 200 est symétrique par rapport à un axe passant par le milieu de la petite base 202 et le milieu de la grande base 201. Ainsi, par exemple, les jonctions entre la première partie P1 et la deuxième partie P2 et entre la première partie P1 et la troisième partie P3 de la courbe 200 présente un même arrondi. De même, les jonctions entre chaque flanc 203 et la petite base 202 présentent un même arrondi, l'angle 2031 de flanc 203 entre le flanc 203 gauche et la grande base 201 et l'angle 2031 de flanc 203 entre le flanc 203 droit et la grande base 201 ont la même valeur et la largeur 2030 du flanc 203 droit et la largeur 2030 du flanc 203 gauche est la même.

La topographie de cette courbe 200 peut alors être caractérisée par les grandeurs suivantes : la longueur 2010, 2020 du motif 3010, la hauteur 2000 du motif 3010, la valeur de l'arrondi entre la première partie P1 et la deuxième partie P2 de la courbe 200 appelée courbure basse 2011, la valeur de l'arrondi entre un flanc 203 et la petite base 202 appelée courbure haute 2021 et l'angle 2031 de flanc 203.

Dans un cas plus complexe où la courbe 200 ne présente pas d'axe de symétrie, la topographie de la courbe 200 peut être caractérisée par la longueur 2010, 2020 du motif 3010, la hauteur 2000 du motif 3010, la courbure basse 2011 droite, la courbure basse 2011 gauche, la courbure haute 2021 droite, la courbure haute 2021 gauche, l'angle 2031 de flanc 203 droit et l'angle 2031 de flanc 203 gauche.

La topographie d'un motif 3010 peut avoir une réalité plus complexe comme une forme en « T » ou encore plusieurs pentes le long du flanc, voire des flancs courbes. Ainsi, pour des formes très lointaines du cas trapézoïdal arrondi, le modèle peut être complexifié en prenant en compte des ordres supérieurs pour les droites et des points de ruptures plus nombreux.

Le calcul des grandeurs topographiques caractérisant la modélisation 200 permet donc d'obtenir la modélisation 200 et d'ainsi estimer la topographie de chaque motif 3010 de l'échantillon 301. Ces calculs sont réalisés à l'aide d'un modèle mathématique à partir d'images acquises par un microscope électronique à balayage, selon les étapes de la méthode 100 selon un premier aspect de l'invention.

On entend par « modèle mathématique », un ensemble d'équations permettant de calculer les grandeurs caractéristiques d'une modélisation.

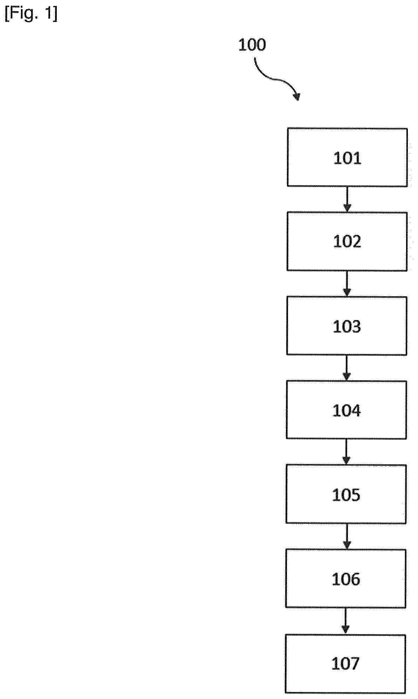

[Fig 1] montre un schéma synoptique des étapes de la méthode 100 selon un premier aspect de l'invention.

Une première étape 101 de la méthode 100 consiste à calibrer le modèle mathématique en utilisant des topographies de référence. Le modèle mathématique permet d'obtenir des grandeurs topographiques caractérisant la forme de la modélisation 200 choisie pour estimer la topographie d'un motif 3010 d'un échantillon 301, par exemple les grandeurs topographiques de la courbe 200 épousant certains contours d'un trapèze à coins arrondis, comme par exemple sa hauteur 2000 ou encore son angle 2031 de flanc 203.

Au début de la première étape 101 du procédé 100, le modèle mathématique utilise un jeu de paramètres ayant des valeurs par défaut et la calibration du modèle mathématique vise à modifier la valeur de ces paramètres pour minimiser les erreurs entre les grandeurs topographiques obtenues par le modèle mathématique et les grandeurs topographiques obtenues pour les topographies de référence du motif 3010.

Selon un premier mode de réalisation, les topographies de référence sont obtenues à l'aide d'au moins une technique de microscopie différente de la microscopie électronique à balayage, comme par exemple de la microscopie électronique en transmission ou TEM et de la microscopie à force atomique ou AFM.

Selon un deuxième mode de réalisation, les topographies de référence sont obtenues par simulation numérique.

Il est possible d'utiliser des topographies de référence issues du premier mode de réalisation et des topographies de référence issues du deuxième mode de réalisation.

Chaque topographie de référence est couplée avec une image de microscopie électronique à balayage correspondante. Par exemple, dans le premier mode de réalisation, on réalise consécutivement l'acquisition d'une image d'un motif de test à l'aide d'un microscope à balayage électronique et d'un autre type de microscope, par exemple un microscope AFM. Par exemple, dans le deuxième mode de réalisation, on réalise l'acquisition d'une image d'un motif de test pour lequel on a réalisé une simulation numérique et dont on connaît la topographie, à l'aide d'un microscope à balayage électronique.

La première étape 101 de la méthode 100 consiste à déterminer une première modélisation, ayant la même forme que celle dont le modèle mathématique permet d'obtenir les grandeurs topographiques, qui correspond le mieux avec la topographie de référence trouvée par l'autre technique de microscopie ou par simulation numérique, puis à utiliser le modèle mathématique sur l'image correspondante obtenue par microscopie électronique à balayage et à ajuster le modèle mathématique pour obtenir une seconde modélisation la plus proche de la première modélisation.

On entend par « ajuster le modèle mathématique », le fait de réaliser un procédé de calcul itératif visant à trouver le jeu de paramètres du modèle mathématique qui minimise l'écart entre les grandeurs topographiques obtenues par le modèle mathématique et les grandeurs topographiques considérées comme le plus proche de la réalité correspondant aux grandeurs topographiques déterminées à partir de l'autre technique de microscopie ou par simulation numérique. Dans la pratique, ce procédé de calcul est par exemple mis en œuvre par calculateur en choisissant un des algorithmes connus pour minimiser l'écart, suivant par exemple la méthode dite des moindres carrées.

Pour que le modèle mathématique puisse fonctionner sur une grande variété de motifs différents, il est nécessaire que cette variété soit présente dans les topographies de référence. Ainsi, si l'on veut par exemple pouvoir déterminer la hauteur 2000 de motifs 3010, il faut que le modèle mathématique ait été calibré avec des topographies de référence présentant une variété de hauteurs différentes.

Une fois calibré, le modèle mathématique est opérationnel sur n'importe quel type de motif, quels que soit par exemple sa hauteur 2000 ou son angle 2031 de flanc 203, dès lors que le flanc est géométriquement visible sur les images de microscopie électronique utilisées pour l'estimation de la topologie.

Une deuxième étape 102 de la méthode 100 consiste à réaliser l'acquisition d'une pluralité d'images d'un motif 3010 de l'échantillon 301 dont on cherche à étudier la topographie. Les acquisitions sont réalisées à l'aide d'un microscope électronique à balayage avec plusieurs angles d'incidence différents et éventuellement avec d'autres conditions de prise d'image différentes comme l'accélération des électrons ou encore l'intensité du faisceau électronique.

[Fig 3] montre une représentation schématique d'un microscope électronique à balayage 300 imageant un échantillon 301 avec un certain angle d'incidence 302.

Sur la figure 3, l'échantillon 301 reçoit un faisceau d'électrons en provenance d'un canon à électrons 303, selon un angle d'incidence 302. Des électrons secondaires sont réémis par l'échantillon 301 et interceptés par un imageur 304. Selon l'angle d'incidence 302, l'image acquise par l'imageur 304 est différente.

La variation de l'angle d'incidence est obtenue, soit en inclinant l'échantillon, soit en déviant le faisceau d'électrons à l'aide de bobines magnétiques.

L'angle d'incidence 302 est par exemple compris entre 0° et 15° dans le cas où le faisceau d'électrons est dévié.

Pour obtenir l'estimation d'un flanc 203, il faut par exemple au minimum deux images prises à deux angles d'incidence 302 différents. Cependant, pour une amélioration significative de la précision, il est conseillé de fournir au moins trois images, par exemple à un angle d'incidence 302 nul, à un angle d'incidence 302 faible, et à l'angle d'incidence 302 le plus grand atteignable par l'équipement.

Dans le cas d'une modélisation 200 basée sur un trapèze à coins arrondis, la valeur de la largeur 2030 d'un flanc 203 varie en fonction de l'angle d'incidence 302.

Sur la figure 2, la largeur 2030 du flanc 203 de gauche et la largeur 2030 du flanc 203 de droite sont représentées pour un angle d'incidence 302 nul.

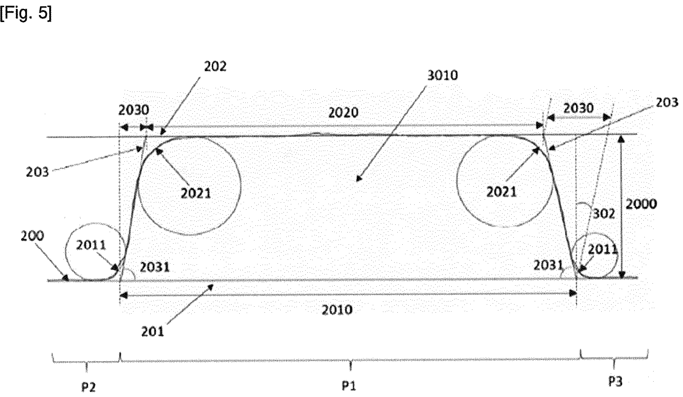

[Fig 5] Sur la figure 5, la largeur 2030 du flanc 203 de gauche est représentée pour un angle d'incidence 302 nul et la largeur 2030 du flanc 203 de droite est représentée pour un angle d'incidence 302 non nul.

Le nombre d'images acquises n'est pas multiplié par le nombre de motifs 3010 de l'échantillon ; deux images de la même zone prises à différents angles d'incidence pourront par exemple estimer tous les flancs de motifs 3010 visibles sur les deux images.

Des troisième 103, quatrième 104, cinquième 105 et sixième 106 étapes de la méthode 100 sont réalisées pour chaque image acquise lors de la deuxième étape 102 de la méthode 100.

La troisième étape 103 de la méthode 100 consiste, pour une image précédemment acquise, à calculer un profil de niveaux de gris selon un axe 1021 donné.

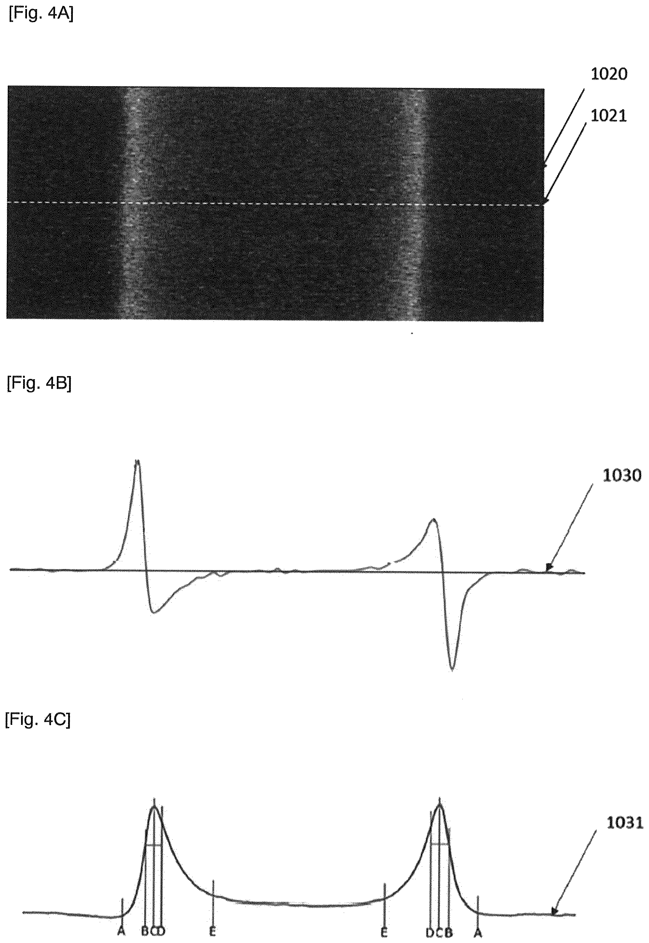

[Fig 4A] représente une image 1020 d'un motif 3010 d'un échantillon 301 acquise par un microscope électronique à balayage.

Une image 1020 comporte deux dimensions : une dimension selon un axe horizontal et une dimension selon un axe vertical. L'axe 1021 est parallèle à l'axe de l'image 1020 qui permet d'obtenir un profil de niveaux de gris non invariant.

Sur la figure 4A, l'axe 1021 est parallèle à l'axe horizontal. En effet, tous les axes de l'image parallèle à l'axe vertical donnent un profil de niveaux de gris invariant.

L'axe 1021 est alors par exemple l'axe horizontal passant par le centre de l'image.

[Fig 4B] représente le profil 1030 de niveaux de gris de l'image 1020 de la figure 4A selon l'axe 1021.

Un profil 1030 de niveaux de gris représente un niveau de gris en fonction d'une position. Un profil 1030 de niveaux de gris selon un axe 1021 représente le niveau de gris de chaque point de l'image situé sur l'axe 1021 en fonction de sa position sur l'axe 1021.

Les niveaux de gris ont une valeur comprise entre 0 et X, la valeur 0 correspondant à la couleur noire et la valeur X correspondant à la couleur blanche, la valeur de X pouvant changée suivant les conventions. X vaut par exemple 1 ou 255.

Sur la figure 4B, le profil 1030 de niveaux de gris présente des pics aux positions correspondant aux zones lumineuses de l'image 1020 situées sur l'axe 1021.

La quatrième étape 104 de la méthode 100 consiste à placer des descripteurs primaires A,B,C,D,E sur le profil 1030 de niveaux de gris précédemment calculé.

Les descripteurs primaires A,B,C,D,E correspondent par exemple à des valeurs particulières de la dérivée du profil 1030 de niveaux de gris.

[Fig 4C] représente la dérivée 1031 du profil 1030 de niveaux de gris de l'image 1020 de la figure 4A selon l'axe 1021, représenté à la figure 4B.

Sur la figure 4C, pour le pic de gauche, le descripteur primaire A correspond à la première position pour laquelle la dérivée 1031 passe d'une valeur nulle à une valeur positive, le descripteur primaire B correspond à la position pour laquelle la dérivée 1031 est maximale, le descripteur primaire C correspond à la position intermédiaire pour laquelle la dérivée 1031 passe d'une valeur positive à une valeur négative, le descripteur primaire D correspond à la position pour laquelle la dérivée 1031 est minimale et le descripteur primaire E correspond à la dernière position pour laquelle la dérivée 1031 passe d'une valeur négative à une valeur nulle. Pour le pic de droite, le descripteur primaire A correspond à la dernière position pour laquelle la dérivée 1031 passe d'une valeur négative à une valeur nulle, le descripteur primaire B correspond à la position pour laquelle la dérivée 1031 est minimale, le descripteur primaire C correspond à la position intermédiaire pour laquelle la dérivée 1031 passe d'une valeur positive à une valeur négative, le descripteur primaire D correspond à la position pour laquelle la dérivée 1031 est maximale et le descripteur primaire E correspond à la première position pour laquelle la dérivée 1031 passe d'une valeur nulle à une valeur positive.

Les descripteurs primaires A,B,C,D,E peuvent également correspondre à des positions pour lesquelles la valeur de niveau de gris ou sa dérivée 1031 ont passé un certain seuil.

Des descripteurs primaires supplémentaires répondant à des règles différentes pourraient être ajoutés pour enrichir le modèle mathématique.

La cinquième étape 105 de la méthode 100 consiste à calculer des descripteurs secondaires et la sixième étape 106 consiste à calculer des grandeurs topographiques primaires à partir des descripteurs secondaires à l'aide du modèle mathématique.

Les grandeurs topographiques primaires sont les grandeurs topographiques de la modélisation 200 pouvant être calculées uniquement à l'aide des descripteurs secondaires et de l'angle d'incidence 302, de l'image 1020 acquise étudiée et éventuellement d'autres conditions de prise d'image.

Dans l'exemple de la courbe 200 épousant certains contours d'un trapèze à coins arrondis, les grandeurs topographiques primaires sont les courbures basses 2011, les courbures hautes 2021 et les largeurs 2030 de flanc 203.

Chaque grandeur topographique primaire est par exemple une combinaison linéaire de descripteurs secondaires se définissant comme une fonction linéaire ou non de plusieurs descripteurs primaires A,B,C,D,E d'une même image 1020 acquise et de l'angle d'incidence 302 correspondant.

Un descripteur secondaire est par exemple |A-B| qui correspond à une distance ou encore $e^{-|A-B|}$ correspondant à une probabilité de sortie des électrons.

Les grandeurs topographiques primaires sont calculées par le modèle mathématique à partir des descripteurs secondaires, l'étape 101 de calibration ayant permis de régler les coefficients constants de chaque combinaison linéaire en minimisant les différences entre les grandeurs topographiques obtenues à partir d'une topographie de référence donnée et les grandeurs topographiques fournies par le modèle mathématique.

Les courbures hautes 2021 dépendent par exemple de |D-E| et de l'angle d'incidence 302. Les courbures basses 2011 dépendent par exemple de |A-B| et de l'angle d'incidence 302. Chaque largeur 2030 de flanc 203 dépend par exemple de |D-B|, de l'angle d'incidence 302, de la courbure haute 2021 et de la courbure basse 2011 correspondants.

A l'issue de la sixième étape 106 de la méthode 100, les grandeurs topographiques primaires sont obtenues pour chaque image 1020 acquise à l'étape 102 d'acquisition.

Par exemple, si trois images 1030 ont été acquises à l'étape 102 d'acquisition dans le cas d'une modélisation 200 dont la forme épouse certains contours d'un trapèze à coins arrondis symétrique, à l'issue de la sixième étape 106 de la méthode 100, neuf grandeurs topographiques primaires sont obtenues : trois courbures basses 2011, trois courbures hautes 2021 et trois largeurs 2030 de flanc 203.

Une septième étape 107 de la méthode 100 consiste à calculer des grandeurs topographiques secondaires à partir des grandeurs topographiques primaires et des angles d'incidence 302 correspondants, et éventuellement des descripteurs secondaires et d'autres conditions de prise d'image de plusieurs images 1020 acquises.

Les grandeurs topographiques secondaires sont les grandeurs topographiques de la modélisation 200 ne pouvant pas être calculées à l'aide d'une unique image 1020 acquise.

Dans l'exemple de la modélisation 200 basée sur un trapèze à coins arrondis symétrique, les grandeurs topographiques secondaires sont la longueur 2020 du motif 3010, la hauteur 2000 du motif 3010 et l'angle 2031 de flanc 203.

Une grandeur topographique secondaire est par exemple une fonction de grandeurs topographiques primaires et d'angles d'incidence 302 et éventuellement d'autres conditions de prise d'image. Une grandeur topographique secondaire est par exemple une fonction de descripteurs secondaires et de grandeurs topographiques primaires précédemment calculées.

Les grandeurs topographiques secondaires sont calculées par le modèle mathématique, l'étape 101 de calibration ayant permis de régler les coefficients constants de chaque fonction en minimisant les différences entre les grandeurs topographiques obtenues à partir d'une topographie de référence donnée et les grandeurs topographiques fournies par le modèle mathématique.

La hauteur 2000 et l'angle 2031 de flanc 203 dépendent par exemple de plusieurs largeurs 2030 de flanc 203 et des angles d'incidence 302 correspondants. La longueur 2020 du motif 3010 dépend par exemple du descripteur secondaire |D-D'| et de l'angle 2031 de flanc 203, où D' est le descripteur primaire du pic de droite et D le descripteur primaire du pic de gauche.

A l'issue de la septième étape 107 de la méthode 100, les grandeurs topographiques primaires et les grandeurs topographiques secondaires sont obtenues pour le motif 3010 imagé à l'étape 102 d'acquisition. L'estimation de la topographie du motif 3010 de l'échantillon 301 est donc obtenue, cette estimation correspondant à la modélisation 200 dont les grandeurs topographiques sont connues. Par exemple, dans le cas d'une modélisation 200 basée sur un trapèze à coins arrondis, la septième étape 107 consiste à fournir la courbe 200 épousant certains contours du trapèze à coins arrondis, correspondante aux grandeurs topographiques précédemment calculées.

L'estimation de la topographie de l'échantillon 301 entier peut par exemple se faire en réalisant les étapes 102 à 107 de la méthode 100 pour chaque motif 3010 de l'échantillon 301.

Dans le cas d'une modélisation 200 basée sur un trapèze à coins arrondis symétrique par rapport à un axe passant par le milieu de la petite base 202 et le milieu de la grande base 201, le modèle mathématique utilisé comprend par exemple les équations suivantes pour calculer les grandeurs topographiques primaires à partir d'une première image 1020 :

$$2011_1 = w_0 + w_1|A - B|$$

$$2021_1 = w_2 + w_3|C{-}E|^2 + w_4|D - E|$$

$$2030_1 = w_5 + w_6\left[|B - D| - e^{-|B-D|}\right] + w_7\left[2011_1 \times 302_1\right]$$

Avec :

- $2011_1$, la courbure basse du motif 3010 correspondant à la première image 1020 ;
- $2021_1$, la courbure haute du motif 3010 correspondant à la première image 1020 ;
- $2030_1$, la largeur de flanc du motif 3010 correspondant à la première image 1020 ;
- $302_1$, l'angle d'incidence avec lequel est prise la première image 1020 ;
- A,B,C,D,E, les descripteurs primaires correspondant à la première image 1020 ;
- $w_0$, $w_1$, $w_2$, $w_3$, $w_4$, $w_5$, $w_6$, des paramètres obtenus lors de la calibration.

Le modèle mathématique utilisé comprend par exemple les équations suivantes pour calculer les grandeurs topographiques secondaires à partir de la première image et d'une deuxième image :

$$2000 = w_8 + w_9\frac{2030_2 - 2030_1}{\tan(302_2) - \tan(302_1)}$$

$$2031 = w_{10} + w_{11}\frac{2030_2 - 2030_1}{2030_1\tan(302_2) - 2030_2\tan(302_1)}$$

$$2020 = w_{12} + w_{13}|E_l - E_r| + w_{14}|D_l - D_r| + w_{15}e^{-\tan(90-2031)}$$

Avec :

- 2000, la hauteur du motif 3010 ;
- $2030_1$, la largeur de flanc du motif 3010 correspondant à la première image 1020 et $2030_2$, la largeur de flanc du motif 3010 correspondant à la deuxième image 1020 ;
- $302_1$, l'angle d'incidence avec lequel est prise la première image 1020 et $302_2$, l'angle d'incidence avec lequel est prise la deuxième image 1020 ;
- 2031, l'angle de flanc du motif 3010 ;
- 2020, la longueur 2020 de la petite base 202 du motif 3010 ; Di, $E_l$ les descripteurs primaires pour le pic de gauche de la dérivée 1031 du profil 1030 de niveaux de gris de la première image 1020 ou de la deuxième image 1020 et $D_r$, $E_r$ les descripteurs primaires pour le pic de droite de la première image 1020 ou de la deuxième image 1020 ;

- $w_8$, $w_9$, $w_{10}$, $w_{11}$, $w_{12}$, $w_{13}$, $w_{14}$, $w_{15}$ des paramètres obtenus lors de la calibration.

## Revendications

1. Méthode (100) d'estimation de la topographie locale d'un échantillon (301) comportant au moins un motif (3010), la méthode (100) comprenant :

   - pour chaque motif (3010) de l'échantillon (301) :

     ◦ une étape (102) d'acquisition, par un microscope électronique à balayage (300), d'une pluralité d'images (1020) du motif (3010), les images (1020) étant prises avec différents angles d'incidence (302) ;
     o pour chaque image (1020) acquise :

       • une étape (103) de calcul d'un profil (1030) de niveaux de gris selon un axe (1021) donné ;
       • une étape (104) de placement d'une pluralité de descripteurs primaires (A,B,C,D,E) sur le profil (1030) de niveaux de gris calculé ;
       • une étape (105) de calcul de descripteurs secondaires à partir des descripteurs primaires (A,B,C,D,E) ;
       • une étape (106) d'utilisation d'un modèle mathématique pour calculer des grandeurs topographiques primaires (2011, 2021, 2030) à partir des descripteurs secondaires ;

     ◦ une étape (107) d'estimation de la topographie locale du motif (3010) consistant à utiliser le modèle mathématique pour calculer des grandeurs topographiques secondaires (2031, 2020, 2000) à partir des grandeurs topographiques primaires (2011, 2021, 2030) et des descripteurs secondaires précédemment calculées.

2. Méthode selon la revendication 1, **caractérisée en ce qu'**elle comporte une première étape (101) de calibration du modèle mathématique à partir de topographies de référence.

3. Méthode selon la revendication 2, **caractérisée en ce que** les topographies de référence sont obtenues à l'aide d'au moins une technique de microscopie différente de la microscopie électronique à balayage.

4. Méthode selon la revendication 3, **caractérisée en ce que** les techniques de microscopie peuvent être choisies parmi la microscopie électronique en transmission ou la microscopie à force atomique.

5. Méthode selon la revendication 2, **caractérisée en ce que** les topographies de référence sont obtenues par simulation numérique.

6. Méthode selon l'une quelconque des revendications précédentes, **caractérisée en ce que** la topographie d'un motif (3010) est modélisée à l'aide d'un trapèze à coins arrondis.

7. Méthode selon la revendication 6, **caractérisée en ce que** le trapèze à coins arrondis comporte une petite base (202), une grande base (201) et deux flancs (203) et peut être **caractérisé par** les huit grandeurs topographiques suivantes : une courbure basse (2011) droite, une courbure basse (2011) gauche, une courbure haute (2021) droite, une courbure haute (2021) gauche, une hauteur (2000), un angle de flanc (2031) droit, un angle de flanc (2031) gauche et une longueur (2010, 2020) à une hauteur donnée.

8. Méthode selon l'une quelconque des revendications précédentes, **caractérisée en ce que** les descripteurs primaires (A,B,C,D,E) sont déterminés à partir de valeurs particulières de la dérivée (1031) du profil (1030) de niveaux de gris selon l'axe (1021) donné.

9. Méthode selon l'une quelconque des revendications précédentes, **caractérisée en ce qu'**une grandeur topographique primaire (2011, 2021, 2030) est une combinaison linéaire de descripteurs secondaires et de l'angle d'incidence (302) d'une unique image (1020) acquise.

10. Méthode selon l'une quelconque des revendications précédentes, **caractérisée en ce qu'**une grandeur topographique secondaire (2031, 2020, 2000) est une fonction de grandeurs topographiques primaires (2011, 2021, 2030) et des angles d'incidence (302) de plusieurs images (1020) acquises et éventuellement des descripteurs secondaires de plusieurs images (1030) acquises.

11. Produit-programme d'ordinateur comprenant des instructions qui, lorsque le programme est exécuté par un ordinateur, conduisent celui-ci à mettre en œuvre les étapes de la méthode (100) selon l'une quelconque des revendications précédentes excepté les étapes d'acquisition.

12. Support d'enregistrement lisible par ordinateur comprenant des instructions qui, lorsqu'elles sont exécutées par un ordinateur, conduisent celui-ci à mettre en œuvre les étapes de la méthode (100) selon l'une quelconque des revendications 1 à 10 excepté les étapes d'acquisition.

**Patentansprüche**

1. Verfahren (100) zur Bemessung der lokalen Topografie einer Probe (301), die mindestens ein Muster (3010) aufweist, wobei das Verfahren (100) umfasst:

- für jedes Muster (3010) in der Probe (301):

  ◦ einen Schritt (102) des Erfassens einer Vielzahl von Bildern (1020) des Musters (3010) durch ein Rasterelektronenmikroskop (300), wobei die Bilder (1020) unter verschiedenen Einfallswinkeln (302) aufgenommen werden;
  ◦ für jedes erfasste Bild (1020):

  - einen Schritt (103) zum Berechnen eines Graustufenprofils (1030) entlang einer gegebenen Achse (1021);
  - einen Schritt (104) des Platzierens einer Vielzahl von primären Deskriptoren (A, B, C, D, E) auf dem berechneten Graustufenprofil (1030);
  - einen Schritt (105) zur Berechnung von sekundären Deskriptoren aus den primären Deskriptoren (A, B, C, D, E);
  - einen Schritt (106) der Anwendung eines mathematischen Modells zur Berechnung von primären topografischen Größen (2011, 2021, 2030) aus den sekundären Deskriptoren;

  ◦ einen Schritt (107) zur Bemessung der lokalen Topografie des Musters (3010), der darin besteht, das mathematische Modell zu verwenden, um sekundäre topografische Größen (2031, 2020, 2000) aus den zuvor berechneten primären topografischen Größen (2011, 2021, 2030) und den sekundären Deskriptoren zu berechnen.

2. Verfahren nach Anspruch 1, **dadurch gekennzeichnet, dass** es einen ersten Schritt (101) zur Kalibrierung des mathematischen Modells anhand von Referenztopografien umfasst.

3. Verfahren nach Anspruch 2, **dadurch gekennzeichnet, dass** die Referenztopografien mithilfe mindestens einer anderen Mikroskopietechnik als der Rasterelektronenmikroskopie erhalten werden.

4. Verfahren nach Anspruch 3, **dadurch gekennzeichnet, dass** die Mikroskopietechniken aus Transmissionselektronenmikroskopie oder Rasterkraftmikroskopie ausgewählt werden können.

5. Verfahren nach Anspruch 2, **dadurch gekennzeichnet, dass** die Referenztopografien durch numerische Simulation gewonnen werden.

6. Verfahren nach einem der vorhergehenden Ansprüche, **dadurch gekennzeichnet, dass** die Topografie eines Musters (3010) mithilfe eines Trapezes mit abgerundeten Ecken modelliert wird.

7. Verfahren nach Anspruch 6, **dadurch gekennzeichnet, dass** das Trapez mit abgerundeten Ecken eine kleine Basis (202), eine große Basis (201) und zwei Flanken (203) aufweist und durch die folgenden acht topografischen Größen charakterisiert werden kann: eine rechte untere Krümmung (2011), eine linke untere Krümmung (2011), eine rechte obere Krümmung (2021), eine linke obere Krümmung (2021), eine Höhe (2000), ein rechter Flankenwinkel (2031), ein linker Flankenwinkel (2031) und eine Länge (2010, 2020) in einer gegebenen Höhe.

8.  Verfahren nach einem der vorhergehenden Ansprüche, **dadurch gekennzeichnet, dass** die primären Deskriptoren (A, B, C, D, E) aus bestimmten Werten der Ableitung (1031) des Graustufenprofils (1030) entlang der gegebenen Achse (1021) bestimmt werden.

9.  Verfahren nach einem der vorhergehenden Ansprüche, **dadurch gekennzeichnet, dass** eine primäre topografische Größe (2011, 2021, 2030) eine Linearkombination aus sekundären Deskriptoren und dem Einfallswinkel (302) eines einzelnen erfassten Bildes (1020) ist.

10. Verfahren nach einem der vorhergehenden Ansprüche, **dadurch gekennzeichnet, dass** eine sekundäre topografische Größe (2031, 2020, 2000) eine Funktion von primären topografischen Größen (2011, 2021, 2030) und der Einfallswinkel (302) mehrerer erfasster Bilder (1020) und möglicherweise der sekundären Deskriptoren mehrerer erfasster Bilder (1030) ist.

11. Computerprogrammprodukt, das Anweisungen umfasst, die, wenn das Programm von einem Computer ausgeführt wird, diesen dazu veranlassen, die Schritte des Verfahrens (100) nach einem der vorhergehenden Ansprüche mit Ausnahme der Erfassungsschritte auszuführen.

12. Computerlesbares Aufzeichnungsmedium, das Anweisungen enthält, die, wenn sie von einem Computer ausgeführt werden, diesen dazu veranlassen, die Schritte des Verfahrens (100) nach einem der Ansprüche 1 bis 10 mit Ausnahme der Erfassungsschritte auszuführen.

**Claims**

1.  A method (100) for estimating local topography of a sample (301) including at least one pattern (3010), the method (100) comprising:

    - for each pattern (3010) of the sample (301):

        ○ a step (102) of acquiring, by a scanning electron microscope (300), a plurality of images (1020) of the pattern (3010), the images (1020) being taken at different angles of incidence (302);
        ○ for each image (1020) acquired:

            ▪ a step (103) of calculating a grey level profile (1030) along a given axis (1021);
            ▪ a step (104) of placing a plurality of primary descriptors (A, B, C, D, E) on the greyscale profile (1030) calculated;
            ▪ a step (105) of calculating secondary descriptors from the primary descriptors (A, B, C, D, E);
            ▪ a step (106) of using a mathematical model to calculate primary topographic quantities (2011, 2021, 2030) from the secondary descriptors;

        ○ a step (107) of estimating local topography of the pattern (3010) consisting in using the mathematical model to calculate secondary topographic quantities (2031, 2020, 2000) from the primary topographic quantities (2011, 2021, 2030) and the secondary descriptors previously calculated.

2.  The method according to claim 1, **characterised in** it includes a first step (101) of calibrating the mathematical model from reference topographies.

3.  The method according to claim 2, **characterised in that** the reference topographies are obtained using at least one microscopy technique different from scanning electron microscopy.

4.  The method according to claim 3, **characterised in that** the microscopy techniques can be selected from transmission electron microscopy or atomic force microscopy.

5.  The method according to claim 2, **characterised in that** the reference topographies are obtained by digital simulation.

6.  The method according to any of the preceding claims, **characterised in that** the topography of a pattern (3010) is modelled using a trapezium with rounded corners.

7. The method according to claim 6, **characterised in that** the trapezium with rounded corners includes a small base (202), a large base (201) and two flanks (203) and can be **characterised by** the following eight topographical quantities: a right low curvature (2011), a left low curvature (2011), a right high curvature (2021), a left high curvature (2021), a height (2000), a right flank angle (2031), a left flank angle (2031) and a length (2010, 2020) at a given height.

8. The method according to any of the preceding claims, **characterised in that** the primary descriptors (A,B,C,D,E) are determined from particular values of the derivative (1031) of the grey level profile (1030) along the given axis (1021).

9. The method according to any of the preceding claims, **characterised in that** a primary topographic quantity (2011, 2021, 2030) is a linear combination of secondary descriptors and the angle of incidence (302) of a single image (1020) acquired.

10. The method according to any of the preceding claims, **characterised in that** a secondary topographic quantity (2031, 2020, 2000) is a function of primary topographic quantities (2011, 2021, 2030) and angles of incidence (302) of several images (1020) acquired and optionally secondary descriptors of several images (1030) acquired.

11. A computer program product comprising instructions which, when the program is executed by a computer, cause the same to implement the steps of the method (100) according to any of the preceding claims except for the acquisition steps.

12. A computer-readable recording medium comprising instructions which, when executed by a computer, cause the same to implement the steps of the method (100) according to any of claims 1 to 10 except for the acquisition steps.

[Fig. 1]

[Fig.2]

[Fig. 3]

[Fig. 4A]

1020

1021

[Fig. 4B]

1030

[Fig. 4C]

1031

A  BCD  E          E  DCB  A

[Fig. 5]

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

*   US 2006210143 A